# FASCICULE DE BREVET EUROPEEN

(11) **EP 2 976 443 B1**
(45) Date de publication et mention de la délivrance du brevet: **25.07.2018**
(21) Numéro de dépôt: 14711944.0
(22) Date de dépôt: 13.03.2014
(51) Int. Cl.: C23C 14/06, C23C 14/16, B64C 11/20, F01D 5/28, C23C 28/00, C23C 28/02

(54) **STRUCTURE ANTI-ÉROSION POUR AÉRONEFS**
EROSIONSBESTÄNDIGE STRUKTUR FÜR FLUGZEUGE
ANTI-EROSION STRUCTURE FOR AIRCRAFTS

(30) Priorité: 22.03.2013 FR 1352573
(43) Date de publication de la demande: 27.01.2016
(73) Titulaire: AIRBUS (SAS), 31700 Blagnac (FR); EUROCOPTER, 13725 Marignane Cédex (FR)
(72) Inventeur: LUISET, Benjamin, 39110 La Chapelle sur Furieuse (FR); NAVARRE, Thomas, F-75019 Paris (FR); BOSCHET, Patrick, F-78180 Montigny Le Bretonneux (FR); BILLARD, Alain, F-25400 Exincourt (FR)
(74) Mandataire: Gicquel, Olivier Yves Gérard
(86) Numéro de dépôt international: PCT/EP2014/055000
(87) Numéro de publication internationale: WO 2014/146972

(56) Documents cités:
- EP-A2- 2 172 577
- WO-A1-2010/044936
- US-A1- 2004 213 675
- US-A1- 2005 227 078
- US-A1- 2006 018 760
- US-A1- 2008 102 296
- WEI R ET AL: "Deposition of thick nitrides and carbonitrides for sand erosion protection", SURFACE AND COATINGS TECHNOLOGY, ELSEVIER, AMSTERDAM, NL, vol. 201, no. 7, 20 décembre 2006 (2006-12-20), pages 4453-4459, XP024996009, ISSN: 0257-8972, DOI: 10.1016/J.SURFCOAT.2006.08.091 [extrait le 2006-12-20]
- WEI R ET AL: "Erosion resistance of thick nitride and carbonitride coatings deposited using plasma enhanced magnetron sputtering", PLASMA PROCESSES AND POLYMERS, WILEY - VCH VERLAG, DE, vol. 4, no. S1, 1 janvier 2007 (2007-01-01), pages S693-S699, XP002570666, ISSN: 1612-8850, DOI: 10.1002/PPAP.200731707 [extrait le 2007-05-24]

## Description

### Domaine de l'invention

La présente invention se rapporte au domaine des revêtements anti-érosion pour bord d'attaque d'aéronefs.

La présente invention vise à apporter une solution à l'érosion due à la pluie et due au sable des bords d'attaques d'aéronefs (voilures, pales ...).

Le bord d'attaque peut être constitué d'un métal plus dur (acier ou autre) que la structure qui le supporte. Toutefois, il est tout de même soumis à une érosion qui conduit à son remplacement avant la fin de vie.

### Etat de la technique

Un problème qui se pose aujourd'hui est le suivant : les bords d'attaques de pale d'hélicoptères souffrent principalement de l'érosion due à la pluie et il est nécessaire de remplacer ces bords d'attaques avant la fin de vie de la pale. De plus, il n'existe pas de solution commune à l'érosion due à la pluie et à l'érosion due au sable, notamment pour les pales d'hélicoptères.

L'enjeu est multiple puisque l'érosion représente un coût en maintenance et en réparation, ainsi qu'un coût de fonctionnement de par les pertes aérodynamiques que l'érosion engendre. Enfin, la pose de protection temporaire contre l'érosion sable représente un coût important pour l'utilisateur.

Aujourd'hui, il existe un besoin d'une solution qui retarde l'érosion pluie et qui serait efficace également pour l'érosion sable.

Actuellement, les pales d'hélicoptères sont revêtues d'un feuillard métallique. Ce feuillard peut être réalisé en acier, en titane, en nickel ou bien encore en un alliage de nickel-cobalt. Ces bords d'attaques sont remplacés périodiquement avant la fin de vie des pales.

Pour remédier aux problèmes d'érosion, des solutions temporaires sont mises en oeuvre. Ces solutions temporaires consistent en l'application de rubans adhésifs, ou bien de films polymères qui ont le mérite de bien résister à l'érosion sable, mais l'inconvénient de ne pas résister à la pluie. Les ailes d'avions peuvent également être protégées par des peintures et des vernis qui ont l'inconvénient de se détériorer sous l'interaction avec l'environnement (pluie, sable, impacts...). L'usage de revêtements multicouches métal / céramique protecteurs est également connu dans l'art antérieur, mais pour protéger les pales de turbine, comme illustré par les documents US 2006/0018760 A1 et US 2008/0102296 A1 par exemple.

### Exposé de l'invention

La présente invention entend remédier aux inconvénients de l'art antérieur en proposant une solution qui permet aux aéronefs de bien résister à la fois à l'érosion due au sable, et à l'érosion liée à la pluie.

A cet effet, la présente invention concerne, dans son acception la plus générale, une structure pour voilures d'aéronefs, caractérisée en ce qu'elle comporte une pièce comportant un bord d'attaque en métal, ledit bord d'attaque étant recouvert d'un revêtement ayant une épaisseur inférieure ou égale à vingt micromètres, et présentant une dureté supérieure à six cents en Dureté Vickers (HV), ledit revêtement étant un revêtement en acier inoxydable multicouches constitué d'une superposition de couches avec un faible gradient d'azote et de couches avec un fort gradient d'azote, lesdites couches ayant une épaiseur sensiblement égale à un micromètre. Ainsi, la structure pour aéronefs selon la présente invention constitue une amélioration très importante par rapport aux solutions existantes pour l'érosion due à la pluie et qui a également l'avantage de protéger contre l'érosion due au sable.

Cette structure multicouches permet d'optimiser l'absorption des chocs car les couches ductiles jouent le rôle d'amortisseur. Cette structure multicouches permet d'obtenir une résistance encore meilleure à la fois à l'érosion due au sable, et à l'érosion liée à la pluie

Selon un autre mode de réalisation, ledit revêtement est constitué d'acier inoxydable sous la forme suivante : FeCrNiMnSiN.

Selon un mode de mise en oeuvre particulier, ledit revêtement est obtenu par un procédé de PVD : Phase Vapeur Déposition.

Avantageusement, ledit revêtement présente une dureté comprise entre 1200 et 4000 en Dureté Vickers (HV).

De préférence, ledit revêtement a une épaisseur comprise entre un et dix micromètres.

Selon un mode de réalisation, ledit revêtement est obtenu par un système Magnétron.

Selon une variante, ledit revêtement est obtenu par un procédé d'Arc-PVD.

Selon un mode de mise en oeuvre particulier, ledit revêtement est obtenu par un procédé HiPMS (*« High Power Impulse Magnetron Sputtering »* en terminologie anglo-saxonne).

La présente invention se rapporte également à un aéronef comportant la structure évoquée ci-dessus.

### Brève description des dessins

On comprendra mieux l'invention à l'aide de la description, faite ci-après à titre purement explicatif, d'un mode de réalisation de l'invention, en référence aux Figures dans lesquelles :
- la Figure 1 illustre une structure pour aéronefs conforme à la présente invention dans un mode de réalisation ;
- la Figure 2 illustre la zone optimum de la résistance à l'érosion des revêtements en fonction de leur épaisseur et de leur dureté ; et
- la Figure 3 représente le volume érodé sur les différents échantillons exprimés en fonction du nombre d'impacts de goutte d'eau.

### Description détaillée des modes de réalisation de l'invention

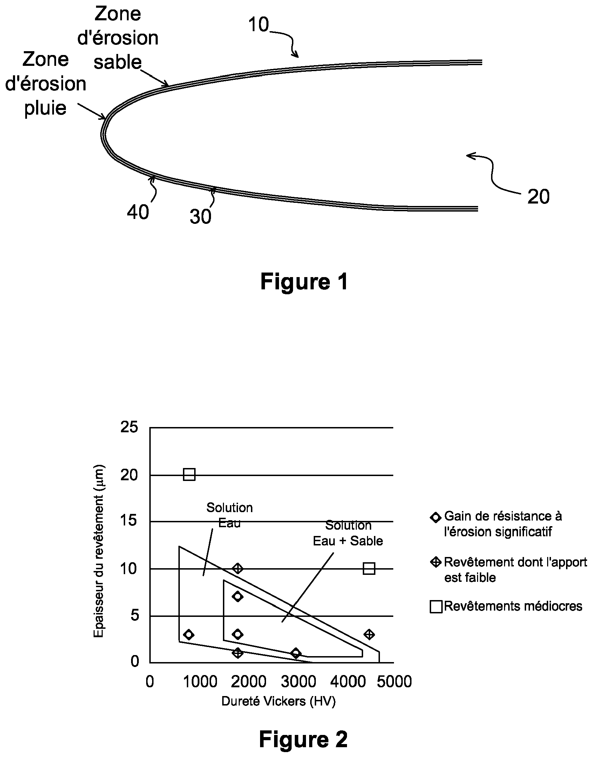

La Figure 1 illustre une structure 10 pour aéronefs conforme à la présente invention dans un mode de réalisation. Ladite structure 10 comporte une pièce 20 comportant un bord d'attaque 30 en métal, ledit bord d'attaque 30 étant recouvert d'un revêtement 40 ayant une épaisseur inférieure ou égale à dix micromètres et présentant une dureté supérieure à six cents en Dureté Vickers (HV).

On voit sur cette Figure 1 quelles sont les zones où l'érosion due au sable s'exerce, et quelles sont les zones où l'érosion due à la pluie s'exerce.

La présente invention constitue une amélioration très importante par rapport aux solutions existantes pour l'érosion due à la pluie et qui a également l'avantage de protéger contre l'érosion due au sable. Il s'agit d'améliorer la tenue de la protection métallique actuelle (le bord d'attaque 30 en métal) par un revêtement 40 très dur et d'épaisseur inférieure à dix micromètres. Selon la présente invention, on protège de façon identique toute la zone du bord d'attaque 30 qui est soumise à l'érosion due à la pluie et/ou à l'érosion due au sable.

Une amélioration significative à l'érosion due à la pluie peut être obtenue dès que le revêtement 40 atteint une épaisseur de l'ordre de un micromètre. En revanche, les tests ont montré que, pour des épaisseurs supérieures à dix micromètres, le revêtement 40 peut se détériorer rapidement.

Dès que la dureté dépasse environ 600 Hv, on obtient une amélioration significative à l'érosion due à la pluie. En revanche, cette dureté est nettement insuffisante pour améliorer l'érosion due au sable. Toutefois, on notera que des duretés supérieures à celle du sable (2000 Hv) améliorent encore la tenue à l'érosion due à la pluie, à condition d'être en faible épaisseur. Comme à ce niveau de dureté, (>2000hv) on améliore la tenue à l'érosion sable, l'idée à l'origine de la présente invention est d'appliquer le même revêtement très dur et d'épaisseur très faible quelle que soit la zone à protéger (pluie ou sable).

L'optimum d'épaisseur semble dépendre de la dureté du revêtement 40. Le graphique de la Figure 2 donne pour différents revêtements la relation entre l'épaisseur et la dureté.

La couche fine et dure permet de résister à la fois à l'érosion due à la pluie et à l'érosion due au sable. Cette couche permet de résister à l'érosion due à la pluie, car elle empêche l'initiation de fissure et elle augmente la capacité d'absorption des chocs en augmentant la surface de répartition des contraintes au sein du substrat, et à l'érosion due au sable, car elle est plus dure que le sable et empêche ce dernier de rayer le revêtement.

La technologie PVD (Phase Vapeur Déposition) permet d'obtenir des matériaux fins, denses avec de très grandes duretés. Les caractéristiques des revêtements et leur résistance ont été augmentées à l'aide du système Magnétron, puis d'une Arc-PVD, puis d'un système HiPIMS (High Power Impulse Magnetron Sputtering).

La technologie PVD permet de déposer une très large gamme de matériaux. Pour optimisation, des revêtements à base de Ti, Cr, Al, Ni, Co, Cu, Zr, Fe, Bo, Mn, Si avec des apports en azote et en carbone ont été développés dans le cadre de la présente invention.

Parmi les revêtements développés dans le cadre de la présente invention, on trouve un acier inoxydable (FeCrNiMnSiN). Le revêtement 40 est un revêtement en acier inoxydable multicouche. Ce revêtement 40 a une épaisseur de sensiblement dix micromètres, et est constitué d'un enchaînement de couches avec un faible gradient d'azote et de couches avec un fort gradient d'azote. Ces couches ont une épaisseur de sensiblement un micromètre. Il n'existe pas d'interface entre les couches car la transition est réalisée par le biais d'un gradient de composition. Cette structure permet d'optimiser l'absorption des chocs car les couches ductiles jouent le rôle d'amortisseur.

Des essais ont été conduits en laboratoire.

Après avoir réalisé des essais jusqu'à cinq millions d'impacts, l'initiation a été reportée de presque deux millions d'impacts.

De plus, en considérant le volume érodé à cinq millions d'impacts, des valeurs équivalentes à celles obtenus sur le substrat nu après seulement deux millions d'impact ont été retrouvées, ce qui représente un gain de trois millions d'impacts.

Enfin, le revêtement multicouches permet de réaliser un gain de 4,5 millions d'impacts sur 5 millions d'impacts, ce qui représente une résistance exceptionnelle à l'érosion.

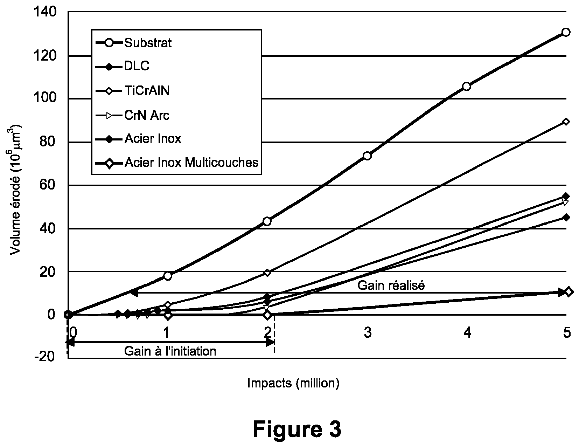

Le graphique de la Figure 3 permet de visualiser les résultats obtenus.

La solution selon la présente invention trouve une application particulièrement avantageuse dans le domaine des hélicoptères afin de renforcer les bords d'attaques des pales d'hélicoptères.

La présente invention s'applique à d'autres types d'aéronefs.

L'invention est décrite dans ce qui précède à titre d'exemple. Il est entendu que l'homme du métier est à même de réaliser différentes variantes de l'invention sans pour autant sortir du cadre du brevet.

## Revendications

1. Structure (10) pour voilures d'aéronefs, **caractérisée en ce qu'**elle comporte une pièce (20) comportant un bord d'attaque (30) en métal, ledit bord d'attaque (30) étant recouvert d'un revêtement (40) ayant une épaisseur inférieure ou égale à vingt micromètres et présentant une dureté supérieure à six cents en Dureté Vickers (HV), et **en ce que** ledit revêtement (40) est un revêtement en acier inoxydable multicouches constitué d'une superposition de couches avec un faible gradient d'azote et de couches avec un fort gradient d'azote, lesdites couches ayant une épaisseur sensiblement égale à un micromètre.

2. Structure (10) pour voilures d'aéronefs selon la revendication 1 **caractérisée en ce que** le matériau dudit revêtement (40) est constitué d'acier inoxydable sous la forme suivante : FeCrNiMnSiN

3. Structure (10) pour voilures d'aéronefs selon l'une au moins des revendications précédentes, **caractérisée en ce que** ledit revêtement (40) est obtenu par un procédé de PVD : Phase Vapeur Déposition.

4. Structure (10) pour voilures d'aéronefs selon l'une au moins des revendications précédentes, **caractérisée en ce que** ledit revêtement (40) présente une dureté comprise entre 1200 et 4000 en Dureté Vickers (HV).

5. Structure (10) pour voilures d'aéronefs selon l'une au moins des revendications précédentes, **caractérisée en ce que** ledit revêtement (40) a une épaisseur comprise entre un et dix micromètres.

6. Structure (10) pour voilures d'aéronefs selon l'une au moins des revendications précédentes, **caractérisée en ce que** ledit revêtement (40) est obtenu par un système Magnétron.

7. Structure (10) pour voilures d'aéronefs selon l'une au moins des revendications précédentes, **caractérisée en ce que** ledit revêtement (40) est obtenu par un procédé d'Arc-PVD.

8. Structure (10) pour voilures d'aéronefs selon l'une au moins des revendications précédentes, **caractérisée en ce que** ledit revêtement (40) est obtenu par un procédé HiPMS (« *High Power Impulse Magnetron Sputtering* » en terminologie anglo-saxonne).

9. Aéronef comportant une structure pour voilures selon l'une au moins des revendications 1 à 8.

## Patentansprüche

1. Struktur (10) für Flugzeugtragflächen, **dadurch gekennzeichnet, dass** sie ein Teil (20) umfasst, das eine Vorderkante (30) aus Metall umfasst, wobei die Vorderkante (30) mit einem Überzug (40) überzogen ist, der eine Dicke kleiner oder gleich zwanzig Mikrometer umfasst und eine Härte von mehr als sechshundert in Härte Vickers (HV) aufweist, und dass der Überzug (40) ein Überzug aus mehrschichtigem Edelstahl ist, der aus einer Schichtung von Schichten mit geringem Stickstoffgradienten und aus Schichten mit hohem Stickstoffgradienten besteht, wobei die Schichten eine Dicke von im Wesentlichen gleich einem Mikrometer haben.

2. Struktur (10) für Flugzeugtragflächen nach Anspruch 1, **dadurch gekennzeichnet, dass** das Material des Überzugs (40) aus Edelstahl in der folgenden Form besteht: FeCrNiMnSiN.

3. Struktur (10) für Flugzeugtragflächen nach mindestens einem der vorhergehenden Ansprüche, **dadurch gekennzeichnet, dass** der Überzug (40) erhalten wird mit einem PVD-Verfahren: physikalische Gasphasenabscheidung.

4. Struktur (10) für Flugzeugtragflächen nach mindestens einem der vorhergehenden Ansprüche, **dadurch gekennzeichnet, dass** der Überzug (40) eine Härte zwischen 1200 und 4000 in Härte Vickers (HV) aufweist.

5. Struktur (10) für Flugzeugtragflächen nach mindestens einem der vorhergehenden Ansprüche, **dadurch gekennzeichnet, dass** der Überzug (40) eine Dicke zwischen einem und zehn Mikrometern hat.

6. Struktur (10) für Flugzeugtragflächen nach mindestens einem der vorhergehenden Ansprüche, **dadurch gekennzeichnet, dass** der Überzug (40) mit einem Magnetron-System erhalten wird.

7. Struktur (10) für Flugzeugtragflächen nach mindestens einem der vorhergehenden Ansprüche, **dadurch gekennzeichnet, dass** der Überzug (40) mit einem Arc-PVD-System erhalten wird.

8. Struktur (10) für Flugzeugtragflächen nach mindestens einem der vorhergehenden Ansprüche, **dadurch gekennzeichnet, dass** der Überzug (40) mit einem HiPIMS-Verfahren (im Englischen "High Power Impulse Magnetron Sputtering") erhalten wird.

9. Flugzeug mit einer Struktur für Tragflächen nach mindestens einem der Ansprüche 1 bis 8.

## Claims

1. Structure (10) for aircraft wings, **characterized in that** it comprises a part (20) comprising a leading edge (30) made of metal, said leading edge (30) being covered with a coating (40) having a thickness of less than or equal to twenty micrometres and having a hardness of greater than six hundred on the Vickers hardness (HV) scale, and **in that** said coating (40) is a multi-layered stainless steel coating made up of a stack of layers having a small nitrogen gradient and of layers having a large nitrogen gradient, said layers having a thickness essentially equal to one micrometre.

2. Structure (10) for aircraft wings according to Claim 1, **characterized in that** the material of said coating (40) consists of stainless steel in the following form: FeCrNiMnSiN.

3. Structure (10) for aircraft wings according to at least one of the preceding claims, **characterized in that** said coating (40) is obtained by a PVD (physical vapour deposition) method.

4. Structure (10) for aircraft wings according to at least one of the preceding claims, **characterized in that** said coating (40) has a hardness of between 1200 and 4000 on the Vickers hardness (HV) scale.

5. Structure (10) for aircraft wings according to at least one of the preceding claims, **characterized in that** said coating (40) has a thickness of between one and ten micrometres.

6. Structure (10) for aircraft wings according to at least one of the preceding claims, **characterized in that** said coating (40) is obtained by means of a magnetron system.

7. Structure (10) for aircraft wings according to at least one of the preceding claims, **characterized in that** said coating (40) is obtained by means of an Arc-PVD method.

8. Structure (10) for aircraft wings according to at least one of the preceding claims, **characterized in that** said coating (40) is obtained by means of a HiPIMS (High Power Impulse Magnetron sputtering) method.

9. Aircraft comprising a structure for wings according to at least one of Claims 1 to 8.
